**Europäisches Patentamt**

**European Patent Office**

**Office européen des brevets**

(19)

(11) Veröffentlichungsnummer: **0 150 327**
**B1**

# EUROPÄISCHE PATENTSCHRIFT

(12)

(45) Veröffentlichungstag der Patentschrift:
**29.06.88**

(21) Anmeldenummer: **84114418.1**

(22) Anmeldetag: **28.11.84**

(51) Int. Cl.⁴: **G 01 R 1/073**

(54) **Kontaktiervorrichtung.**

(30) Priorität: **30.11.83 DE 3343274**

(43) Veröffentlichungstag der Anmeldung:
**07.08.85 Patentblatt 85/32**

(45) Bekanntmachung des Hinweises auf die Patenterteilung:
**29.06.88 Patentblatt 88/26**

(84) Benannte Vertragsstaaten:
**AT BE CH DE FR GB IT LI NL SE**

(56) Entgegenhaltungen:
**DE-A-2 063 198**
**DE-B-1 790 052**
**FR-A-2 511 197**
**US-A-4 232 928**

(73) Patentinhaber: **Feinmetall Gesellschaft mit beschränkter Haftung, Zeppelinstrasse 2, D-7033 Herrenberg (DE)**

(72) Erfinder: **Krüger, Gustav, Dr. Dipl.- Phys., Danziger Strasse 1, D-7033 Herrenberg (DE)**

(74) Vertreter: **König, Oskar, Dr.- Ing. Dipl.- Phys., Klüpfelstrasse 6 Postfach 51, D-7000 Stuttgart 1 (DE)**

EP 0 150 327 B1

## Beschreibung

Die Erfindung betrifft eine Kontaktiervorrichtung für eine Prüf- oder Meßeinrichtung gemäß dem Oberbegriff des Anspruches 1.

Prüf- oder Meßeinrichtungen dieser Art sind bekannt (Krüger, "Prüfmittel zur elektrischen Prüfung von Leiterplatten für Uhren", Jahrbuch der Deutschen Gesellschaft für Chronometrie, Band 30, 1979, S. 269-276)

Eine bekannte Kontaktiervorrichtung der im Oberbegriff des Anspruches 1 genannten Art (DE-B-1 790 052) weist eine Vielzahl von in einen Trägerblock eingesetzten federnden Tastelementen auf, wobei jedes Tastelement aus zwei einzeln federnden Tastfedern besteht, welche in einer Ebene mäanderförmig gebogene, flache Federn sind, die in Bohrungen eines plattenförmigen Lagerkörpers und in Öffnungen von am Lagerkörper beidseits plan anliegenden Abdeckplatten jeweils paarweise mit ihren flachen Seiten aneinanderliegend geführt sind. Diese paarweise die Tastelemente bildenden Federn sind gewellte Blattfedern, die keine Drähte sind und relativ viel Platz benötigen und sehr kleine Mittenabstände zwischen benachbarten Federpaaren nicht zulassen. Auch ist der bauliche Aufwand für die Federpaare verhältnismäßig groß. Zum Anschluß dieser Federn sind ihre geradlinig verlaufenden rückwärtigen Federenden in den Öffnungen der rückwärtigen Abdeckplatte jeweils paarweise geführt, wobei diese Federenden Anschlußfahnen für elektrische Leiter und/oder gedruckte bzw. geätzte Leiterbahnen bilden.

Eine andere bekannte Kontaktiervorrichtung (DE-A-2 839 982) weist als Kontaktstifte sogenannte Federkontaktstifte auf. Der einzelne Federkontaktstift besteht aus einem in einer hinteren Platte des Trägers fest eingesetzten Zylinder, in welchem ein durch eine Feder belasteter Kolben angeordnet ist, an dem ein flexibler Kontaktdraht befestigt ist, der ein biegsames Mantelrohr durchdringt, welches Mantelrohr vom Zylinder aus in einer Biegung zur vorderen Platte des Trägers geführt und in einer Bohrung von ihr diese durchdringend befestigt ist. Über dieses Mantelrohr ragt der Kontaktdraht mit seinem die Kontaktspitze aufweisenden Endbereich hervor. Die Biegungen der Mantelrohre der Federkontaktstifte dienen dazu, um die Zylinder in der hinteren Platte des Trägers in größeren Abständen voneinander in gespreizter Anordnung als die in der vorderen Platte befindlichen Bereiche ihrer hier zueinander parallelen Mantelrohrbereiche anzuordnen, um so besonders geringe Mittenabstände benachbarter Kontaktspitzen der Kontaktdrähte zu erreichen. Die axiale Federung dieser Federkontaktstifte wird durch den beweglichen, federbelasteten Kolben im Zylinder bewirkt. Diese Kontaktiervorrichtung ist baulich aufwendig und eignet sich wegen der gespreizten Anordnung der Zylinder in der hinteren Platte nur für nicht sehr große Anzahlen von Federkontaktstiften, so daß ihr Anwendungsbereich beschränkt ist.

Es ist ferner eine Kontaktiervorrichtung bekannt (US-A-4 232 928), bei der dem Kontaktieren von zu prüfenden Leiterplatten dienende starre Kontaktstifte axial beweglich gelagert und durch eine pneumatisch belastbare Membran an die jeweils zu prüfende Leiterplatte andrückbar sind. Diese Kontaktstifte sind mittels flexiblen, separaten, sie umwindenden Drähten mit durch dieselbe Membran belastbaren, starren und ebenfalls axial beweglichen, von diesen Drähten umwundenen Kontaktstiften elektrisch verbunden, die an unbewegliche Gegenkontakte angedrückt werden, an die zu einem Kabel zusammengefaßte, weitere separate Drähte sie umwindend angeschlossen sind. Dieses Kabel führt zu einer Prüfeinrichtung. Diese Kontaktiervorrichtung ist jedoch baulich sehr aufwendig und der elektrische Anschluß jedes dem Kontaktieren von zu prüfenden Leiterplatten dienenden Kontaktstiftes an das Kabel benötigt bis zum Kabel mehrere elektrische Verbindungsstellen, an denen elektrische Leiter in Kontakt miteinander verbunden sind, was schon wegen der hier auftretenden elektrischen Übergangswiderstände unerwünscht ist, da diese sich unkontrolliert ändern und auch sonstwie stören können.

Es ist deshalb Aufgabe der Erfindung, eine Kontaktiervorrichtung der im Oberbegriff des Anspruches 1 genannten Art zu schaffen, welche bei einfacher, kostengünstiger Bauart Anordnungen auch sehr großer Anzahlen von Kontaktstiften in geringen Mittenabständen nebeneinander zuläßt, wobei auch erreicht werden soll, daß sich diese Kontaktiervorrichtung auf einfache, variable Weise selbst in schwierigen Fällen an die Prüf- oder Meßeinrichtung elektrisch anschließen läßt.

Zur Lösung dieser Aufgabe ist erfindungsgemäß eine Kontaktiervorrichtung gemäß Anspruch 1 vorgesehen.

Indem jeder Kontaktstift zusammen mit dem ihm zugeordneten Verlängerungsdraht durch einen einzigen einstückigen Draht gebildet ist, ist diese Kontaktiervorrichtung baulich äußerst einfach und kostengünstig. Auch werden hierdurch optimale elektrische Eigenschaften erreicht, da zwischen dem Kontaktstift und dem Verlängerungsdraht keine unkontrollierbaren elektrischen Übergangswiderstände verursachenden Schnittstellen, Lötstellen, Schweißstellen oder sonstige Verbindungsstellen vorhanden sind. Dies ist bei derartigen Kontaktiervorrichtungen, die dem Prüfen von Leiterplatten oder dergl. dienen, äußerst vorteilhaft, da elektrischte Übergangswiderstände Fehler bei der Auswertung der elektrischen Signale, die über die Kontaktstifte und Verlängerungsdrähte übertragen werden, entstehen können, wobei sich solche elektrischen Übergangswiderstände oft im Laufe der Betriebszeit auch unkontrolliert erhöhen können. Durch die Einstückigkeit des Kontaktstiftes mit dem Verlängerungsdraht werden solche Fehler also auf äußerst einfache und dazu noch kostengünstige Weise vermieden. Die Kontaktstifte sind für ihre Funktion elastisch, so daß sie gut federn können. Die zu mindestens einem Kabel zusammengefaßten Verlängerungsdrähte sind dagegen nicht federnd oder allenfalls nur wenig federnd, was vorteilhaft ist.

Der Träger mit den Kontaktstiften bildet einen über das mindestens eine flexible Kabel mit dem Anschlußglied verbundenen baulich äußerst einfachen und kostengünstigen Prüf- oder Meßkopf, der es infolge des oder der Kabel auch ermöglicht, ihn in unterschiedlichen Stellungen an der Prüf- oder Meßeinrichtung anzuordnen oder ihn auch vom Gehäuse der Prüf- oder Meßeinrichtung im Abstand bspw. an einem gesonderten Prüftisch anzuordnen. Die Kontaktiervorrichtung ermöglicht die Anordnung praktisch beliebig großer Anzahlen von Kontaktstiften in geringen Mittenabständen voneinander, bspw. an Rasterpunkten eines engen Rasters oder in sonstigen gewünschten Anordnungen.

Die räumliche Trennung des Anschlußgliedes von dem Träger kann gemäß einer bevorzugten Weiterbildung der Erfindung dazu ausgenutzt werden, um die Mittenabstände der am Anschlußglied einander benachbarten Anschlußkontakte größer, vorzugsweise mehr als doppelt so groß als die Mittenabstände einander benachbarter Kontaktstifte am Träger vorzusehen. Dies vereinfacht und verbilligt das Anschlußglied und erleichtert auch den Anschluß der weiterführenden elektrischen Leiter an es.

Einige vorteilhafte Weiterbildungen und Ausgestaltungen der Erfindung sind in den Unteransprüchen beschrieben.

In der Zeichnung sind Ausführungsbeispiele der Erfindung dargestellt. Es zeigen:

Fig. 1 ein Ausführungsbeispiel einer Kontaktiervorrichtung gemäß der Erfindung in schematischer, ausschnittsweiser Darstellung,

Fig. 2 einen geschnittenen Ausschnitt aus dem einen Prüf- oder Meßkopf bildenden Träger der Fig. 1,

Fig. 3 einen Teilschnitt durch Fig. 2, gesehen entlang der Schnittlinie 3-3,

Fig. 4 einen Teilschnitt durch Fig. 2, gesehen entlang der Schnittlinie 4-4,

Fig. 5 und 6 je einen Teilschnitt durch Prüf- oder Meßköpfe gemäß weiteren Ausführungsbeispielen der Erfindung.

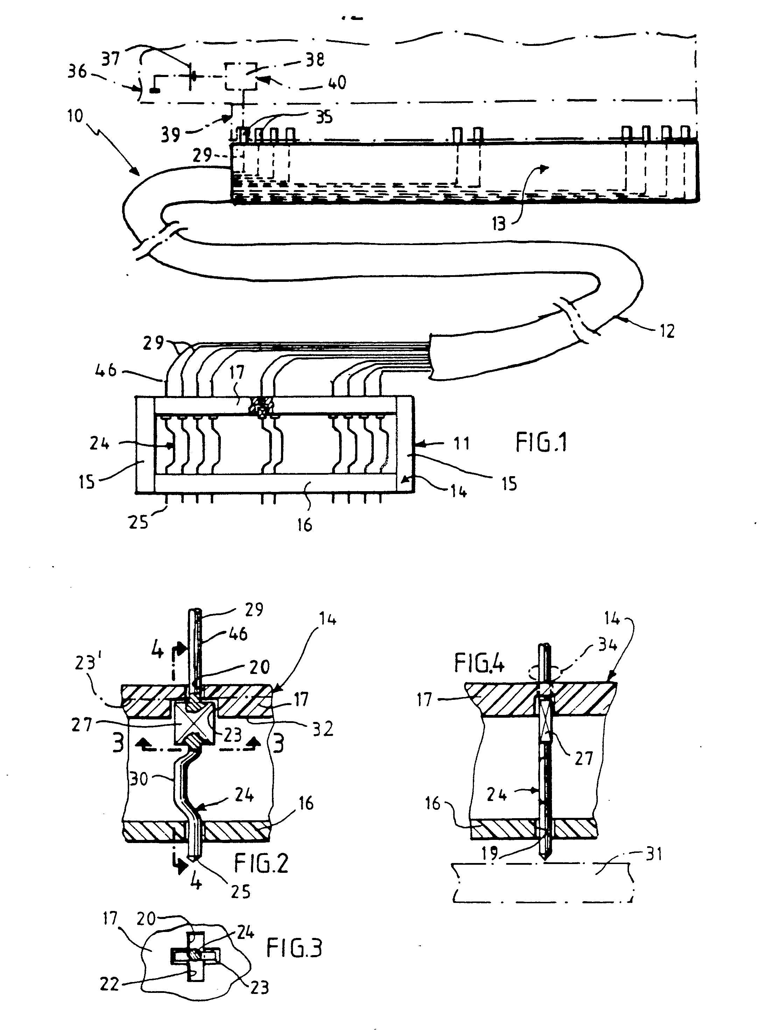

Die Kontaktiervorrichtung 10 nach Fig. 1 bis 4 weist einen Prüf- oder Meßkopf 11 und ein mit ihm über ein flexibles Kabel 12 verbundenes, als Steckerleiste ausgebildetes Anschlußglied 13 auf.

Der Prüf- oder Meßkopf 11 weist einen starren Träger 14 auf, der zwei durch Leisten 15 miteinander verbundene, zueinander parallele Platten 16, 17 aus elektrisch isolierendem Material, bspw. aus Kunststoff, Keramik oder dergl., aufweist. Sowohl die vordere Platte 16 als auch die hintere Platte 17 weisen eine Vielzahl von sie senkrecht durchdringenden Löchern 19, 20 auf, von denen die Löcher 19 in der vorderen Platte 16 als gerade Bohrungen kreisrunden Querschnittes ausgebildet sind. Die Löcher 20 in der hinteren Platte 17, von denen jedes mit einem zugeordneten Loch 19 in der vorderen Platte 16 fluchtet, weisen dagegen jeweils einen Durchgangsschlitz 22 rechteckförmigen Querschnittes und eine den Durchgangsschlitz senkrecht kreuzende Quernut 23 auf. In jedes solches miteinander fluchtende Lochpaar 19, 20 kann ein Kontaktstift 24 eingesteckt sein, wie er in den Fig. 2 bis 4 in näheren Einzelheiten dargestellt ist. Der massive Kontaktstift 24 ist ein federnder Metalldraht, an den ab der Stelle 46 ein mit ihm einstückiger, schlaffer mindestens 40 cm langer Verlängerungsdraht 29 anschließt. Hierzu kann dieser Draht aus einem Werkstoff hergestellt sein, der durch Wärmebehandlung oder sonstige Behandlung auf dem Bereich, auf welchem er den Kontaktstift 24 bildet, federnde Eigenschaften erhält, wogegen der restliche Bereich dieses Drahtes, der den Verlängerungsdraht 29 bildet, seine nichtfedernde oder allenfalls nur wenig federnde und im übrigen relativ schlaffe Eigenschaft behält, indem er in diesem Bereich nicht vergütet wird. Andere Möglichkeiten zu erreichen, daß das Metall des Kontaktstiftes 24 federnd und das Metall des Verlängerungsdrahtes 29 nicht oder kaum federnd ist, sind weiter unten beschrieben.

Der beim Abtasten eines elektrischen, insbesondere elektronischen Prüflings 31, wie einer Leiterplatte oder dergl., von diesem Prüfling 31 auf den Kontaktstift 24 ausgeübte axiale Druck führt zum axialen Verschieben der Kontaktspitze 25 unter entsprechendem Verbiegen der Ausbiegung 30, wobei sich dieser Kontaktstift 24 mit seiner Flachdrückung 27 am Grund der Quernut 23 abstützt, hier also gegen axiales Verschieben durch die hier für ihn als Widerlager dienende hintere Platte 17 gesichert ist. In der Ruhestellung liegt der federnde Kontaktstift 24 mit dem unteren Ende seiner Ausbiegung 30 an der Rückseite der vorderen Platte 16 des Trägers 14 vorzugsweise unter Vorspannung an, so daß er sich in dieser Ruhestellung nicht nach unten bewegen kann. Er ist damit durch die Ausbiegung 30 und die Flachdrückung 27 in der in Fig. 2 dargestellten Ruhestellung gehalten.

Die Montage des Kontaktstiftes 24 kann auf einfache Weise von der Rückseite des Trägers 14 her erfolgen, indem man den Kontaktstift mit der Spitze 25 voran in das Loch 20 in der hinteren Platte 17 einführt und ihn dann nach unten bewegt und dann seine Spitze 25 in das Loch 19 der vorderen Platte 16 einführt und er wird dann noch so lang nach unten bewegt, bis die Flachdrückung 27 unter die Ebene der Vorderseite 32 der hinteren Platte 17 gelangt ist. Dann wird er um 90° gedreht und unter Nachlassen des auf ihn ausgeübten Druckes gelangt dann seine Flachdrückung 27 in die Quernut 23, wodurch er gegen Drehen gesichert wird. Der Kontaktstift 24 kann dann freigegeben werden und hält sich dann von selbst in der in Fig. 2 dargestellten Ruhestellung. Die Herausnahme des Kontaktstiftes kann in umgekehrter Folge geschehen.

Der Außenumfang des Verlängerungsdrahtes 29 ist mit einer ihn elektrisch isolierenden Ummantelung, bspw. aus einem Isolierlack, einer elektrisch isolierenden Hülle oder dergl., versehen. Indem dieser Verlängerungsdraht 29 biegeschlaff ist, kann er keine wesentlichen axialen Kräfte auf den Kontaktstift 24 ausüben. Sollte jedoch die Gefahr bestehen, daß dieser Verlängerungsdraht 29 auf den Kontaktstift 24 störende axiale Kräfte ausüben kann, kann man vorsehen, den den Schlitz 23 mit Gleitlagerspiel durchdringenden Kontaktstift 24 unmittelbar oberhalb der Rückseite der hinteren Platte 17 mit einer in Fig. 4 strichpunktiert angedeuteten Flachdrückung 34 vor oder nach seinem Einsetzen zu versehen, so daß er in den Träger 14 von dessen Rückseite aus nicht weiter eingeführt werden kann.

Die beiden Platten 16, 17 weisen eine Vielzahl von Lochpaaren 19, 20 zur Aufnahme von Kontaktstiften 24 auf, wobei sehr geringe Mittenabstände zwischen benachbarten Kontaktstiften 24 möglich sind, da diese Kontaktstifte 24 nur sehr geringe Drahtdurchmesser von bspw. weniger als 0,2 mm und sehr geringe Querdimensionen von bspw. weniger als 0,5 mm zu haben brauchen, erwünschtenfalls natürlich auch mehr. Der Draht des Kontaktstiftes 24 muß elastisch sein wegen der axialen Eigenfederung.

Alle Verlängerungsdrähte 29 sind zu dem nach außen elektrisch isolierten Kabel 12 zusammengefaßt und dieses Kabel 12 endet an der beweglichen Steckerleiste 13, die ein aus elektrischem Isoliermaterial, bspw. aus Kunststoff bestehendes Gehäuse hat, an dessen einer Seite elektrische Steckerstifte 35 gegeneinander elektrisch isoliert angeordnet sind. Jeder Verlängerungsdraht 29 ist an einen nur ihm zugeordneten Steckerstift 35 angeschlossen.

In Fig. 1 sind nur einige wenige der normalerweise sehr vielen an einem solchen Träger 14 vorhandenen Kontaktstift 24 und entsprechend auch nur einige wenige Steckerstifte 35 dargestellt.

Die Steckerstifte 35 der Steckerleiste 13 werden an der im weiteren nur strichpunktiert ausschnittsweise angedeuteten Meß- oder Prüfeinrichtung 36 in Steckerbuchsen einer Steckerbuchsenleiste 39 eingesteckt, was äußerst einfachen und raschen Anschluß des Anschlußgliedes 13 und jederzeitige Wiederabnahme ermöglicht.

Jeder Kontaktstift 24 mit Verlängerungsdraht 29 und Steckerstift 35 stellt einen elektrischen Leiter dar, der bei jeder Prüfung oder Messung eines Prüflings 31 eine elektrische Verbindung zwischen einer elektrischen Auswerteschaltung, wie 40, und einer vorbestimmten, durch die Kontaktspitze 25 zu kontaktierenden Stelle des Prüflinges 31 schafft. Dabei wird die Kontaktspitze 25 durch den Prüfling 31 etwas nach oben bewegt unter federndem Biegen der Biegung 30 des Kontaktstiftes 24, so daß die Kontaktspitze 25 mit für eine sichere Kontaktgabe ausreichend großer Kraft auf die zu prüfende oder zu messende Stelle des Prüflinges 31 drückt.

Die in Fig. 1 dargestellte Auswerteschaltung 40 weist eine Gleichspannungsquelle 37 und eine Signalvorrichtung 38 auf, die einen Fehler immer dann bei jeder Prüfung oder Messung meldet, wenn der Prüf- oder Meßstrom vorgegebene Grenzwerte überschreitet und/oder unterschreitet.

Der Kontaktstift 24 besteht aus federndem, hochwertigem Metalldraht, bspw. aus Kupfer-Beryllium, Kupfer-Zirkon, Federstahl, Neusilber, aus härtbaren Edelmetall-Legierungen oder ähnlichen Werkstoffen, die gute elektrische Leitfähigkeit und gute federnde Eigenschaften haben und der aus demselben Metall bestehende Verlängerungsdraht 29 kann seine schlappe oder nahezu schlappe Eigenschaft bspw. wie oben beschrieben erhalten.

Der Längsschlitz 23 kann ggfs. auch ein durchgehender Längsschlitz 23 sein, in welchen alle Flachdrückungen 27 derselben Reihe von Kontaktstiften 24 zu ihrer Drehsicherung eingreifen.

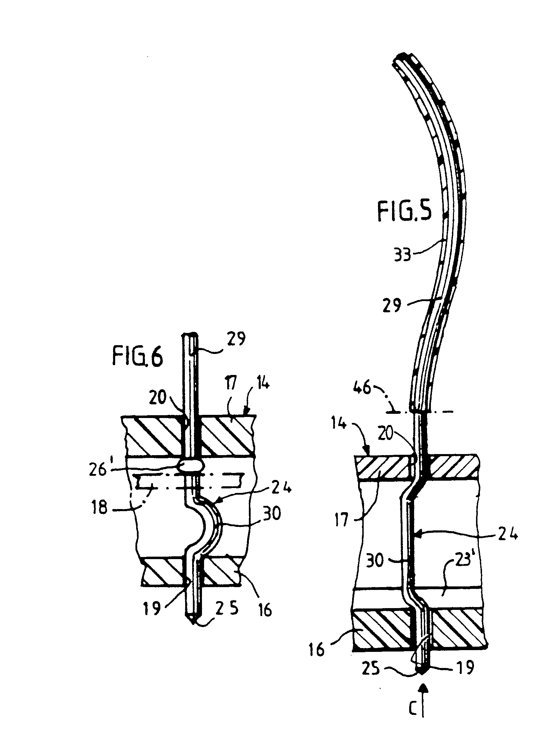

In Fig. 5 weist der Kontaktstift 24 eine sich über die gesamte lichte Höhe des Zwischenraumes zwischen den von ihm mit Gleitlagerspiel durchdrungenen beiden Bohrungen 19, 20 der Platten 16, 17 des Trägers 14 erstreckende U-förmige Ausbiegung 30 auf, die seiner axialen Eigenfederung und seiner axialen Lagesicherung dient.

Die beiden den durchgehend aus federndem Runddraht bestehenden Kontaktstift 24 aufnehmenden Bohrungen 19, in den Platten 16, 17 fluchten wiederum miteinander. Das untere Ende der Ausbiegung 30 liegt in einer Längsnut 23' der vorderen Platte 16 zur Drehsicherung dieses Kontaktstiftes 24.

Diese Drehsicherung hat, wie auch in den anderen Ausführungsbeispielen - sofern sie eine Drehsicherung der Kontaktstifte 24 haben - , den Zweck, engere Mittenabstände zwischen in derselben Reihe und/oder in benachbarten Reihen benachbarten Kontaktstiften 24 ohne Gefahr von Inkontaktkommen zu ermöglichen, indem die Kontaktstifte 24 zueinander ausgerichtet bleiben.

Wenn der Kontaktstift 24 durch einen Prüfling in Richtung des Pfeiles C axial belastet wird, verschiebt sich seine Kontaktspitze 25 unter Ausbiegung der Biegung 30 in Richtung des Pfeiles C nach oben, wobei er in der Bohrung 19 der vorderen Platte 16 gleitet. Dabei verhindert das obere Ende der Ausbiegung 30, indem es an der Platte 17 anliegt, daß sich der Kontaktstift im Loch 20 axial verschieben kann. An diesen Kontaktstift 24 schließt einstückig ein Verlängerungsdraht 29 an. Zu diesem Zweck kann der Draht, der gemeinsam sowohl den Verlängerungsdraht 29 als auch den Kontaktstift 24 bildet, wie bereits erwähnt, aus einem Werkstoff hergestellt sein, der durch Wärmebehandlung oder sonstige Behandlung auf dem Bereich, auf welchem er den Kontaktstift 24 bildet - dies ist in diesem Ausführungsbeispiel der Bereich von der Kontaktspitze 25 bis zur strichpunktierten Linie 46 - federnde Eigenschaften erhält, wogegen der restliche Bereich dieses Drahtes, der den Verlängerungsdraht 29 bildet, seine nichtfedernde oder allenfalls nur wenig federnde und im übrigen relativ schlaffe Eigenschaft behält, indem er in diesem Bereich nicht vergütet wird. Der Verlängerungsdraht 29 ist mit einer, geschnitten dargestellten, ihn elektrisch isolierenden Ummantelung 33 versehen, damit er im Kabel 12 (Fig. 1) keinen elektrischen Kontakt mit den anderen Verlängerungsdrähten 29 erhalten kann.

Der Kontaktstift 24 kann ebenfalls in seiner Ruhestellung bereits vorgespannt sein, indem seine an die beiden Platten 16, 17 anstoßende Ausbiegung 30 durch diese Platten bereits etwas zusammengedrückt ist.

Bei der Ausführungsform nach Fig. 6 ist der dargestellte Kontaktstift 24 nicht gegen Drehen gesichert. Er hat also von den benachbarten, nicht dargestellten Kontaktstiften so viel Abstand, daß in keiner Winkelstellung die Gefahr von Kontakten mit diesen besteht, oder er ist in dem Bereich, wo Kontaktgefahr mit benachbarten Kontaktstiften besteht, mit einer elektrisch isolierenden Ummantelung versehen. Dieser Kontaktstift 24 reicht in diesem Ausführungsbeispiel von seiner Spitze 25 nur bis zu einer verbreiterten Stelle 26', an welche der Verlängerungsdraht 29 schließt. Diese verbreiterte Stelle 26' liegt an der der vorderen Platte 16 zugewendeten ebenen Seite der hinteren Platte 17 des Trägers 14 an, damit sich diese Stelle 26 bei axialer Belastung der Kontaktspitze 25 durch einen Prüfling nicht verschieben kann. Der schlaffe Verlängerungsdraht 29 beginnt also direkt an der Stelle 26'. Auch in diesem Ausführungsbeispiel kann die Ausbiegung 30 des den Kontaktstift 24 bildenden federnden Drahtes so getroffen sein, daß dieser Kontaktstift 24 in der dargestellten Ruhestellung bereits vorgespannt ist, damit die Stelle 26 ständig durch die Vorspannung an die hintere Platte 17 angedrückt ist. Die Vorspannung ist ausreichend hoch, um sicherzustellen, daß der schlappe Verlängerungsdraht 29 sie nicht überwinden kann, so daß die Stelle 26' ständig an der hinteren Platte 17 anliegen bleibt.

Der Mantel des Kabels 12 in Fig. 1 kann durch Umwicklung, einen Schrumpfschlauch oder dergl. gebildet sein.

Es ist auch möglich, zur axialen Lagesicherung des Kontaktstiftes in beiden axialen Richtungen noch eine dritte Platte 18 am Träger 14 fest anzuordnen, wie es im Ausführungsbeispiel der Fig. 6 strichpunktiert eingezeichnet ist. Diese Platte 18 ist parallel zu den beiden anderen Platten und an ihrer der Platte 17 zugewendeten Oberseite liegt die verbreiterte Stelle 26' an, so daß sie durch die beiden Platten 17 und 18 am axialen Verschieben gehindert ist. Die Biegung 30 des Kontaktstiftes 24 braucht dann im Ruhezustand nicht an der vorderen Platte 16 anzuliegen, sondern kann höher oder enger vorgesehen sein.

Man kann bspw. auch dadurch erreichen, daß das Metall des Kontaktstiftes 24 federnd und das Metall des Verlängerungsdrahtes 29 nicht oder kaum federnd, sondern praktisch schlaff ist, indem man den den Verlängerungsdraht 29 bildenden Bereich des Gesamtdrahtes ausglüht. Der den Kontaktstift 24 bildende Bereich dieses Gesamtdrahtes kann bspw. aus Stahl bestehen und durch Härtung und Anlassen seine guten federnden Eigenschaften erhalten. Im Bereich des Verlängerungsdrahtes können ihm diese federnden Eigenschaften bspw. durch Glühen wieder genommen werden.

Bei der Ausführungsform nach den Fig. 2 - 4 hat der Kontaktstift 24 im in der Platte 17 befindlichen Längsschlitz 22 infolge seines hier runden Querschnittes in Längsrichtung des Schlitzes 22 sehr viel Spiel und in Querrichtung des Schlitzes 22 Gleitlagerspiel. Damit er in Längsrichtung des Schlitzes 22 nicht ausbiegen kann, ist die Länge der Quernut 23 nur so groß, daß in ihr die Flachdrückung 27 nur geringes Seitenspiel hat, so daß hierdurch der Kontaktstift auch in der hinteren Platte 17 mit nur geringem Seitenspiel geführt ist.

## Patentansprüche

1. Kontaktiervorrichtung für eine Prüf- oder Meßeinrichtung zum elektrischen Prüfen oder Messen elektrischer, insbesondere elektronischer Prüflinge, z. B. von Leiterplatten oder dgl., mit einer Vielzahl von länglichen, elektrisch leitenden, axial federnden Kontaktelementen (24), die an einem starren Träger (14) angeordnet sind, der zwei im Abstand voneinander angeordnete Platten (16, 17) aufweist, von denen die vordere Platte (16) von den Kontaktelementen durchdrungene Löcher (19) aufweist, über die sie überstehen, wobei diese Kontaktelemente im Zwischenraum zwischen den beiden Platten (16, 17) des Trägers (14) zur Herbeiführung ihrer axialen Eigenfederung gebogen und im Bereich der vorderen Platte (16) axial beweglich geführt sind und die der vorderen Platte (16) zugewendete Seite der hinteren Platte (17) ein Widerlager für das Kontaktelement (24) zu dessen Abstützung gegen von Prüflingen auf es ausgeübte axiale Kräfte bildet, dadurch gekennzeichnet, daß das Kontaktelement jeweils einen einzigen federnden Kontaktstift (24) bildet, der in dem ihm zugeordneten Loch (19) der vorderen Platte (16) mit Gleitlagerspiel geführt ist, daß an den Kontaktstift (24) ein mindestens 40 cm langer, flexibler Verlängerungsdraht (29) anschließt, daß der Kontaktstift (24) oder der Verlängerungsdraht ein Loch (20) der hinteren Platte (17) durchdringt, daß der Kontaktstift (24) und der an ihn anschließende Verlängerungsdraht (29) aus einem einstückigen Draht besteht, der im Bereich des Kontaktstiftes (24) federnde Eigenschaften und im Bereich des Verlängerungsdrahtes (29) nichtfedernde oder nur wenig federnde Eigenschaften aufweist, und daß die Verlängerungsdrähte (29) gegeneinander elektrisch isoliert zu mindestens einem flexiblen Kabel zusammengefaßt zu einem Anschlußglied (13) geführt sind, wo sie an elektrische Anschlußkontakte (35) dieses Anschlußgliedes angeschlossen sind.

2. Kontaktiervorrichtung nach Anspruch 1, dadurch gekennzeichnet, daß der Kontaktstift (24) zum Teil oder vollständig aus Runddraht besteht.

3. Kontaktiervorrichtung nach Anspruch 1 oder 2, dadurch gekennzeichnet, daß der Verlängerungsdraht (29) oder der Kontaktstift (24) in der hinteren Platte (17) des Trägers (14) mit Seitenspiel, vorzugsweise mit geringem Seitenspiel geführt ist.

4. Kontaktiervorrichtung nach einem der vorhergehenden Ansprüche, dadurch gekennzeichnet, daß der Mittenabstand benachbarter Anschlußkontakte (35) des Anschlußgliedes (13) größer, vorzugsweise mehr als doppelt so groß als der Abstand der Kontaktspitzen (25) der zugeordneten, benachbarten Kontaktstifte (24) voneinander ist.

5. Kontaktiervorrichtung nach einem der vorhergehenden Ansprüche, dadurch gekennzeichnet, daß die einem Kontaktstift (24) zugeordneten beiden Löcher (19, 20) der vorderen und der hinteren Platte (16, 17) miteinander fluchten.

6. Kontaktiervorrichtung nach einem der vorhergehenden Ansprüche, dadurch gekennzeichnet, daß der Kontaktstift (24) am Träger gegen Drehen gesichert angeordnet ist, vorzugsweise durch Formschluß.

7. Kontaktiervorrichtung nach Anspruch 6, dadurch gekennzeichnet, daß der Kontaktstift zu seiner Sicherung gegen Drehen mit seiner Biegung (30) und/oder mit einem ebenen Bereich (27) in einen Schlitz oder eine Nut (23; 23') der vorderen Platte (16) und/oder der hinteren Platte (17) eingreift.

8. Kontaktiervorrichtung nach einem der vorhergehenden Ansprüche, dadurch gekennzeichnet, daß der Kontaktstift an der hinteren Platte formschlüssig gegen axiales Verschieben in beiden Richtungen gesichert ist, vorzugsweise durch Hülsen, Verbreiterungen oder dergl., die zu beiden Seiten der hinteren Platte (17) an dem Kontaktstift und/oder am Verlängerungsdraht vorgesehen sind.

9. Kontaktiervorrichtung nach einem der vorhergehenden Ansprüche, dadurch gekennzeichnet, daß der Kontaktstift einen scheibenförmigen Bereich (27) aufweist, daß zum Einführen dieses Bereiches in den Zwischenraum in der hinteren Platte (17) als Durchgangsloch ein Schlitz (22) vorgesehen ist, durch den dieser verbreiterte Bereich (27) zum Einsetzen des Kontaktstiftes (24) in den Träger hindurchführbar ist, und daß in der der vorderen Platte (16) zugewendeten Seite der hinteren Platte (17) dieser Schlitz von einer Quernut (23) gekreuzt wird, in die dieser ebene Bereich (27) einsetzbar ist.

10. Kontaktiervorrichtung nach einem der vorgehenden Ansprüche, dadurch gekennzeichnete daß der Verlängerungsdraht (29) ein schlaffer Draht ist.

11. Kontaktiervorrichtung nach einem der Ansprüche 1 - 7, 9 oder 10, dadurch gekennzeichnet, daß zur axialen Lagesicherung des Kontaktstiftes (24) er und/oder der Verlängerungsdraht einen verbreiterten Bereich (26') aufweist, der zwischen der hinteren Platte (17) und einer weiteren vom Kontaktstift oder dem Verlängerungsdraht durchdrungenen Platte (18) des Trägers (14) angeordnet und durch diese gegen axiales verschieben gesichert ist.

**Claims**

1. A contacting apparatue for a testing or measuring device for electrically testing or measuring electrical, in particular electronic, test pieces, for example of printed circuit boards or the like, with a plurality of elongate, electrically conductive, axially resilient contact elements (24) which are disposed on a rigid support (14) which comprises two plates (16, 17), which are arranged at a distance from each other and of which the front plate (16) has holes (19) through which the contact elements pass and beyond which they project, the said contact elements being bent in the interspace between the two plates (16, 17) of the support (14) for effecting their inherent dial resilience and being guided axially movably in the region of the front plate (16), and the side of the rearplate (17) which face the front plate (16) forming an abutment for the contact element (14) to support it against axial forces exerted by test pieces upon it, characterized in that the contact element forms in each case a single resilient contact pin (24) which is guided with sliding bearing clearance in the hole (19) of the front plate (16) associated with it, a flexible extension wire (29) at least 40 cm long being joined to the contact pin (24), the contact pin (24) or the extension wire passing through a hole (20) in the rear plate (17), the contact pin (24) and the extension wire (29) joined thereto consisting of a one-piece wire which in the region of the contact pin (24) has resilient characteristics and in the region of the extension wire (29) non-resilient characteristics or only slightly resilient characteristics, and the extension wires (29) are combined, electrically insulated from one another, to form at least one flexible cable and guided to form a connexion member (13), where they are joined to electrical connecting contacts (35) of the said connexion member.

2. A contacting apparatus according to Claim 1, characterized in that the contact pin (24) consists partly or completely of round wire.

3. A contacting apparatus according to Claim 1 or 2, characterized in that the extension wire (29) or the contact pin (24) is guided in the rear plate (17) of the support (14) with lateral clearance, preferably wit slight lateral clearance.

4. A contacting apparatus according to any one of the preceding Claims, characterized in that the centre-to-centre distance of adjacent connecting contacts (35) of the connexion member (13) is greater than, and preferably more than twice as large as, the distance between the contact points (25) of the associated, adjacent contact pins (24) from one another.

5. A contacting apparatus according to any one of the preceding Claims, characterized in that the two holes (19, 20) of the front and rear plates (16, 17) associated with one contact pin (24) are in alignment with each other.

6. A contacting apparatus according to any one of the preceding Claims, characterized in that the contact pin (24) is mounted on the support so as to be prevented from rotating, preferably by positive locking.

7. A contacting apparatus according to Claim 6, characterized in that, in order to prevent it from rotating, the contact pin engages with its bent portion (30) and/or with a flat area (27) in a slot or a groove (23; 23') in the front plate (16) and/or the rear plate (17).

8. A contacting apparatus according to any one of the preceding Claims, characterized in that the contact pin is prevented from being displaced axially in both directions on the rear plate by positive locking, preferably by sleeves, widened portions or the like, which are provided on both sides of the rear plate (17) on the contact pin and/or on the extension wire.

9. A contacting apparatus according to any one of the preceding Claims, characterized in that the contact pin has a sheet-shaped area (27), a slot (22), through which the said widened area (27) can be passed for introducing the contact pin (24) into the support, is provided as a through hole for inserting the said area into the interspace in the rear plate (17), and in the side of the rear plate (17) facing the front plate (16) the said slot is crossed by a transverse groove (23) into which the said flat area (27) can be inserted.

10. A contacting apparatus according to any one of the preceding Claims, characterized in that the extension wire (29) is a limp wire.

11. A contacting appratus according to any of Claims 1 to 7, 9 or 10, characterized in that, in order to secure the position of the contact pin (24) axially, the latter and/or the extension wire comprises a widened area (26') which is arranged between the rear plate (17) and a further plate (19) of the support (14) traversed by the contact pin or the extension wire and is prevented from being displaced axially by the said plate (18).

**Revendications**

1. Dispositif de mise en contact pour une installation de vérification ou de mesure destinée à vérifier ou mesurer des éprouvettes électriques, en particulier électroniques, par exemple des plaquettes de circuit ou élément de ce genre, comportant une pluralité d'éléments de contact (24) longitudinaux, conducteurs électriquement, axialement élastiques, qui sont disposés sur un support rigide (14) possédant deux plaques (16, 17) disposées à une certaine distance l'une de l'autre, desquelles la plaque avant (16) possède des trous (19) traversés par les éléments de contact et au-delà desquels elles se dressent, ces éléments de contact étant à cette occasion courbés dans l'espace intermédiaire qui est situé entre les deux plaques (16, 17) du support (14), afin de provoquer leur élasticité propre axialement et étant guidés de manière mobile axialement, dans la zone de la plaque avant (16), et le côté de la plaque arrière (17), qui est tourné vers la plaque avant (16), forme une butée pour l'élément de contact (24) pour son appui face aux forces axiales exercées par les éprouvettes sur lui,

caractérisé en ce que l'élément de contact (24) forme à chaque fois une tige de contact (24) unique et élastique qui est guidée dans le trou (19) de la plaque avant qui lui est associé, avec un jeu de glissement, en ce que la tige de contact (24), est raccordée par un fil de prolongement (29) flexible et d'une longueur d'au moins 40 cm de long, en ce que la tige de contact (24) ou bien le fil de prolongement traverse un trou (20) de la plaque arrière (17), en ce que la tige de contact (24) et le fil de prolongement (29) qui s'y raccorde sont composés d'une seule pièce, qui présente des propriétés élastiques dans la zone de la tige de contact (24) et des propriétés non élastiques, ou bien seulement peu élastiques dans la zone du fil de prolongement (29) et que les fils de prolongement (29) sont isolés entre eux électriquement et rassemblés en au moins un câble flexible et guidés vers un organe de raccordement (13), où ils sont raccordés à des contacts de raccordement électrique de cet organe de raccordement.

2. Dispositif de mise en contact selon la revendication 1, caractérisé en ce que la tige de contact (24) se compose partiellement ou bien complètement de fil rond.

3. Dispositif de contact selon la revendication 1 ou 2, caractérisé en ce que le fil de prolongement (29), ou bien la tige de contact (24), est guidée dans la plaque arrière (17) du support (14), avec un jeu latéral, de préférence avec un faible jeu latéral.

4. Dispositif de mise en contact suivant l'une des revendications précédentes, caractérisé en ce que la distance entre axes des contacts de raccordement (35) adjacent à l'organe de raccordement (13) est plus grande, de préférence est plus du double de la distance des pointes de contact (25) des tiges de contact (24) voisines associées.

5. Dispositif de mise en contact selon l'une des revendications précédentes, caractérisé en ce que les deux trous (19, 20) de la plaque avant et de la plaque arrière (16, 17) et qui sont affectés à une tige de contact (24), sont alignés ensemble.

6. Dispositif de mise en contact selon l'une des revendications précédentes, caractérisé en ce que la tige de contact (24) est disposée sur le support, de manière assurée contre la rotation, de préférence par un ajustement mécanique.

7. Dispositif de mise en contact selon la revendication 6, caractérisé en ce que la tige de contact vient en prise avec sa courbure (30) et/ou une zone plane (27), dans une fente ou bien une gorge (23 ; 23') de la plaque avant (16) et/ou de la plaque arrière (17), pour assurer sa sécurité contre toute rotation.

8. Dispositif de mise en contact selon l'une des revendications précédentes, caractérisé en ce que la tige de contact est assurée à la plaque arrière contre tout déplacement axial dans les deux directions, par l'interpénétration de forme, de préférence par des douilles, des élargissements, ou similaires, qui sont prévus des deux côtés de la plaque arrière (17), sur la tige de contact et/ou sur le fil de prolongement.

9. Dispositif de mise en contact selon l'une des revendications précédentes, caractérisé en ce que la tige de contact possède une zone (27) en forme de disque, qu'une fente (22) est prévue comme trou de passage, pour l'introduction de cette zone dans l'espace intermédiaire, dans la plaque arrière (17) et au travers de laquelle on peut faire passer cette zone élargie (27), pour introduire la tige de contact (24) dans le support et en ce que cette fente de la gorge transversale (23) se croise, dans le côté de la plaque arrière (17) qui est tourné vers la plaque avant (16) et dans laquelle on peut introduire cette zone plane (27).

10. Dispositif de mise en contact selon l'une des revendications précédentes, caractérisé en ce que le fil de prolongement (29) est un fil souple.

11. Dispositif de mise en contact selon l'une des revendications 1 à 7, 9 ou 10, caractérisé en ce que pour assurer la sécurité axiale de la tige de contact (24), celle-ci et/ou le fil de prolongement possède une zone élargie (26'), qui est disposée entre la plaque arrière (17) et une autre plaque (18) du support (14), qui est traversée par la tige de contact ou bien par le fil de prolongement et est assurée par celle-ci contre tout déplacement axial.

FIG.1

FIG.2

FIG.3

FIG.4

FIG.5

FIG.6